(19) Europäisches Patentamt
European Patent Office
Office européen des brevets

(11) EP 4 657 503 A1

(12) **EUROPEAN PATENT APPLICATION**
published in accordance with Art. 153(4) EPC

(43) Date of publication:
**03.12.2025 Bulletin 2025/49**

(21) Application number: **23919739.5**

(22) Date of filing: **02.02.2023**

(51) International Patent Classification (IPC):
***H01L 21/304*** *(2006.01)*

(52) Cooperative Patent Classification (CPC):
**H01L 21/304**

(86) International application number:
**PCT/JP2023/003437**

(87) International publication number:
**WO 2024/161602 (08.08.2024 Gazette 2024/32)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Resonac Corporation**
**Tokyo 105-7325 (JP)**

(72) Inventor: **KURATA, Yuto**
**Tokyo 105-7325 (JP)**

(74) Representative: **Hoffmann Eitle**
**Patent- und Rechtsanwälte PartmbB**
**Arabellastraße 30**
**81925 München (DE)**

# (54) POLISHING LIQUID, POLISHING LIQUID SET, POLISHING METHOD, COMPONENT MANUFACTURING METHOD, AND SEMICONDUCTOR COMPONENT MANUFACTURING METHOD

(57) A polishing liquid containing: abrasive grains; an additive; and water, in which the additive includes (A1) a compound having two or more nitrogen atoms to which a hydroxyalkyl group is bonded and (B) a 4-pyrone-based compound represented by General Formula (1) below. A polishing liquid containing: abrasive grains; an additive; and water, in which the additive includes (A2) a polyglycerol and (B) a 4-pyrone-based compound represented by General Formula (1) below.

[Chemical Formula 1]

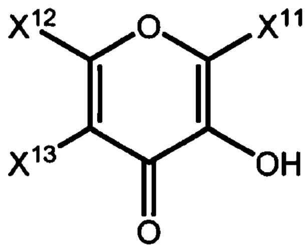

(1)

[In the formula, $X^{11}$, $X^{12}$, and $X^{13}$ are each independently a hydrogen atom or a monovalent substituent.]

EP 4 657 503 A1

## Description

### Technical Field

The present disclosure relates to a polishing liquid, a polishing liquid set, a polishing method, a method for manufacturing a component, a method for manufacturing a semiconductor component, and the like.

### Background Art

In the field of semiconductor production, with achievement of high performance of ultra LSI devices, a miniaturization technology as an extension of the conventional technology finds restriction in allowing high integration and speed-up to be compatible with each other. Accordingly, techniques for allowing vertical high integration (namely, techniques for developing multilayered wiring) while miniaturization of semiconductor elements have been developed.

In the process for manufacturing a device including multilayered wiring, one of the most important techniques is a CMP (chemical mechanical polishing) technique. The CMP technique is a technique that flattens a surface of a member to be polished obtained by forming a thin film on a substrate by chemical vapor deposition (CVD) or the like. For example, a flattening treatment by CMP is essential to ensure the depth of focus in lithography. When the surface of the member to be polished has irregularities, there occur, for example, such troubles that the focusing in an exposure step is precluded, and a fine wiring structure cannot be sufficiently formed. Furthermore, the CMP technique is also applied to the step of forming element isolation (isolation between elements; STI: shallow trench isolation) regions by polishing of plasma oxide films (such as BPSG, HDP-$SiO_2$, and p-TEOS); the step of forming an ILD film (interlayer insulating film; an insulating film electrically insulating metal members (wirings and the like) in the same layer); the step of flattening plugs (for example, Al or Cu plugs) after embedding a film containing silicon oxide in a metal wiring; and the like in device manufacturing process.

CMP is usually performed using an apparatus capable of supplying a polishing liquid onto a polishing member (a polishing pad or the like). Further, a surface to be polished of a member to be polished is polished by pressing the member to be polished against the polishing member while a polishing liquid is supplied between the surface to be polished (surface) of the member to be polished and the polishing member. Thus, in the CMP technique, a polishing liquid is one of elemental technologies, and various polishing liquids have also been hitherto developed in order to obtain a high-performance polishing liquid (see, for example, Patent Literature 1 below).

### Citation List

### Patent Literature

Patent Literature 1: Japanese Unexamined Patent Publication No. 2008-288537

### Summary of Invention

### Technical Problem

In a case where a surface to be polished of a member to be polished is polished by using a polishing liquid, from the viewpoint of enhancing the flatness of a polished surface after polishing, it is required to obtain excellent in-plane uniformity of a polishing rate of a surface to be polished. On the other hand, in a case where a surface to be polished of a member to be polished is polished by using a polishing liquid, the polishing rate may be unstable at an outer peripheral part of the surface to be polished with about 3 mm from an outer periphery, due to reasons such as a pressure applied during polishing being unstable. Therefore, from the viewpoint of evaluating a stable polishing rate, the in-plane uniformity of the polishing rate in an inner region remaining on a surface to be polished excluding an outer peripheral part may be evaluated.

An object of an aspect of the present disclosure is to provide a polishing liquid capable of obtaining excellent in-plane uniformity of a polishing rate of an inner region on a surface to be polished excluding an outer peripheral part. An object of another aspect of the present disclosure is to provide a polishing liquid set for obtaining the above-described polishing liquid. An object of another aspect of the present disclosure is to provide a polishing method using the above-described polishing liquid. An object of another aspect of the present disclosure is to provide a method for manufacturing a component by using a polished member polished by the above-described polishing method. An object of another aspect of the present disclosure is to provide a method for manufacturing a semiconductor component by using a polished member polished by the above-described polishing method.

**Solution to Problem**

The present disclosure relates to the following [1] to [15] and the like in several aspects.

[1] A polishing liquid containing: abrasive grains; an additive; and water, in which the additive includes (A1) a compound having two or more nitrogen atoms to which a hydroxyalkyl group is bonded and (B) a 4-pyrone-based compound represented by General Formula (1) below:

[Chemical Formula 1]

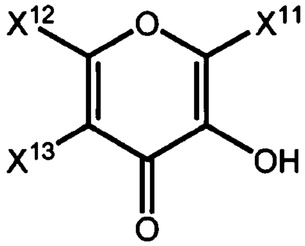

(1)

[in the formula, $X^{11}$, $X^{12}$, and $X^{13}$ are each independently a hydrogen atom or a monovalent substituent.]

[2] The polishing liquid described in [1], in which the component (A1) includes an ethylenedinitrilotetraethanol.

[3] The polishing liquid described in [1] or [2], in which the component (A1) includes an ethylenedinitrilotetrapropanol.

[4] The polishing liquid described in any one of [1] to [3], in which a content of the component (A1) is 0.001 to 5% by mass.

[5] A polishing liquid containing: abrasive grains; an additive; and water, in which the additive includes (A2) a polyglycerol and (B) a 4-pyrone-based compound represented by General Formula (1) below:

[Chemical Formula 2]

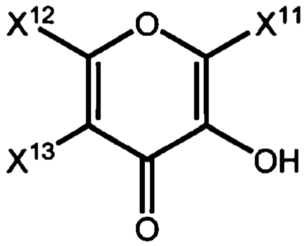

(1)

[in the formula, $X^{11}$, $X^{12}$, and $X^{13}$ are each independently a hydrogen atom or a monovalent substituent.]

[6] The polishing liquid described in [5], in which a content of the component (A2) is 0.001 to 10% by mass.

[7] The polishing liquid described in any one of [1] to [6], in which the abrasive grains contain a cerium-based compound.

[8] The polishing liquid described in any one of [1] to [7], in which the component (B) includes at least one selected from the group consisting of 3-hydroxy-2-methyl-4-pyrone, 5-hydroxy-2-(hydroxymethyl)-4-pyrone, and 2-ethyl-3-hydroxy-4-pyrone.

[9] The polishing liquid described in any one of [1] to [8], in which a content of the component (B) is 0.001 to 5% by mass.

[10] The polishing liquid described in any one of [1] to [9], in which the additive further includes a saturated monocarboxylic acid.

[11] The polishing liquid described in any one of [1] to [10], in which a pH is 8.00 or less.

[12] A polishing liquid set, containing: constituent components of the polishing liquid described in any one of [1] to [11], separately stored as a first liquid and a second liquid, in which the first liquid contains the abrasive grains and water, and the second liquid contains at least one of the additive, and water.

[13] A polishing method including a step of polishing a surface to be polished of a member to be polished by using the polishing liquid described in any one of [1] to [11].

[14] A method for manufacturing a component, including obtaining a component by using a polished member polished by the polishing method described in [13].

[15] A method for manufacturing a semiconductor component, including obtaining a semiconductor component by

using a polished member polished by the polishing method described in [13].

## Advantageous Effects of Invention

According to an aspect of the present disclosure, it is possible to provide a polishing liquid capable of obtaining excellent in-plane uniformity of a polishing rate of an inner region on a surface to be polished excluding an outer peripheral part. According to another aspect of the present disclosure, it is possible to provide a polishing liquid set for obtaining the above-described polishing liquid. According to another aspect of the present disclosure, it is possible to provide a polishing method using the above-described polishing liquid. According to another aspect of the present disclosure, it is possible to provide a method for manufacturing a component by using a polished member polished by the above-described polishing method. According to another aspect of the present disclosure, it is possible to provide a method for manufacturing a semiconductor component by using a polished member polished by the above-described polishing method.

## Description of Embodiments

Hereinafter, an embodiment of the present disclosure will be described in detail.

In the present specification, a numerical range that has been indicated by use of "to" indicates the range that includes the numerical values which are described before and after "to", as the minimum value and the maximum value, respectively. "A or more" in a numerical range means A and a range of more than A. "A or less" in a numerical range means A and a range of less than A. In numerical ranges that are described stepwise in the present specification, the upper limit value or the lower limit value of the numerical range of a certain stage can be arbitrarily combined with the upper limit value or the lower limit value of the numerical range of another stage. In numerical ranges that are described in the present specification, the upper limit value or the lower limit value of the numerical range may be replaced with the value shown in Examples. "A or B" may include either one of A and B, and may also include both of A and B. Materials listed as examples in the present specification can be used singly or in combinations of two or more kinds, unless otherwise specified. When a plurality of substances corresponding to each component exist in the composition, the content of each component in the composition means the total amount of the plurality of substances that exist in the composition, unless otherwise specified. The term "film" includes a structure having a shape which is formed on a part, in addition to a structure having a shape which is formed on the whole surface, when the film has been observed as a plan view. The term "step" includes not only an independent step but also a step by which an intended action of the step is achieved, though the step cannot be clearly distinguished from other steps. A "hydroxy group" (hydroxyl group) does not include an OH structure contained in a carboxy group.

<Polishing liquid>

A polishing liquid of the present embodiment (a first embodiment and a second embodiment; the same applies hereinafter) contains abrasive grains, an additive, and water, in which the additive includes at least one component (A) selected from the group consisting of (A1) a compound having two or more nitrogen atoms to which a hydroxyalkyl group is bonded (component (A1)) and (A2) a polyglycerol (component (A2)), and (B) a 4-pyrone-based compound represented by General Formula (1) below (component (B)). The additive of the polishing liquid of the first embodiment includes (A1) a compound having two or more nitrogen atoms to which a hydroxyalkyl group is bonded (component (A1)) and (B) a 4-pyrone-based compound represented by General Formula (1) below (component (B)). The additive of the polishing liquid of the second embodiment includes (A2) a polyglycerol (component (A2)) and (B) a 4-pyrone-based compound represented by General Formula (1) below (component (B)).

[Chemical Formula 3]

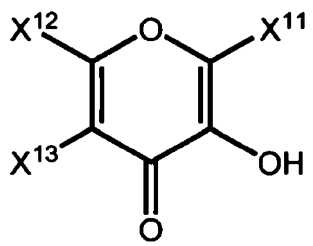

(1)

[In the formula, $X^{11}$, $X^{12}$, and $X^{13}$ are each independently a hydrogen atom or a monovalent substituent.]

The additive of the polishing liquid of the present embodiment may be an embodiment including the component

(A1) but not including the component (A2), may be an embodiment including the component (A2) but not including the component (A1), and may be an embodiment including the component (A1) and the component (A2). The polishing liquid of the present embodiment can be used as a polishing liquid for CMP, and can be used, for example, for polishing silicon oxide.

According to the polishing liquid of the present embodiment, it is possible to obtain excellent in-plane uniformity of a polishing rate of an inner region on a surface to be polished excluding an outer peripheral part, and it is possible to obtain excellent in-plane uniformity of a polishing rate of an insulating material (for example, silicon oxide) of an inner region of a surface to be polished. According to the polishing liquid of the present embodiment, in the evaluation method described in Examples described below, as the in-plane uniformity of a polishing rate of silicon oxide of an inner region remaining on a surface to be polished excluding an outer peripheral part (an outer peripheral part with 3 mm from an outer periphery), for example, 0.95 or less (preferably, 0.90 or less, 0.80 or less, 0.70 or less, 0.60 or less, or the like) can be obtained.

Although a factor by which excellent in-plane uniformity of a polishing rate of an inner region of a surface to be polished can be obtained is not necessarily clear, the factor is speculated as described below. However, the factor is not limited to the contents to be as follows. That is, the pressure applied to the surface to be polished during polishing is non-uniform due to fine irregularities of the surface to be polished, so that the in-plane uniformity of the polishing rate may be deteriorated. On the other hand, in the polishing liquid of the present embodiment, since the component (B) is adsorbed to the surface to be polished or the abrasive grains to alleviate the influence of the pressure on the polishing rate, the in-plane uniformity of the polishing rate is easily improved. Furthermore, in the polishing liquid of the present embodiment, since the component (A) is used to promote compatibility between the surface to be polished and the abrasive grains with the component (B) as a trigger so that the entire surface to be polished is likely to come into uniform contact with the abrasive grains, the in-plane uniformity of the polishing rate is easily improved. Excellent in-plane uniformity of the polishing rate is obtained by these actions.

(Abrasive grains)

The polishing liquid of the present embodiment contains abrasive grains. The abrasive grains can contain a cerium-based compound (a compound containing cerium), alumina, silica, titania, zirconia, magnesia, mullite, silicon nitride, $\alpha$-sialon, aluminum nitride, titanium nitride, silicon carbide, boron carbide, or the like. From the viewpoint of easily obtaining excellent in-plane uniformity of the polishing rate in the inner region of the surface to be polished, the abrasive grains may contain a cerium-based compound.

Examples of the cerium-based compound include cerium oxide, cerium hydroxide, cerium ammonium nitrate, cerium acetate, cerium sulfate hydrate, cerium bromate, cerium bromide, cerium chloride, cerium oxalate, cerium nitrate, and cerium carbonate. From the viewpoint of easily obtaining excellent in-plane uniformity of the polishing rate in the inner region of the surface to be polished, the abrasive grains may contain cerium oxide.

In a case where the abrasive grains contain a cerium-based compound, the content of the cerium-based compound in the abrasive grains may be 50% by mass or more, 70% by mass or more, 90% by mass or more, 95% by mass or more, 97% by mass or more, 98% by mass or more, or 99% by mass or more, on the basis of the whole abrasive grains (the whole abrasive grains contained in the polishing liquid), from the viewpoint of easily obtaining excellent in-plane uniformity of the polishing rate in the inner region of the surface to be polished. The abrasive grains containing a cerium-based compound may be an embodiment substantially composed of a cerium-based compound (an embodiment in which substantially 100% by mass of the abrasive grains is a cerium-based compound).

In a case where the abrasive grains contain cerium oxide, the content of the cerium oxide in the abrasive grains may be 50% by mass or more, 70% by mass or more, 90% by mass or more, 95% by mass or more, 97% by mass or more, 98% by mass or more, or 99% by mass or more, on the basis of the whole abrasive grains (the whole abrasive grains contained in the polishing liquid), from the viewpoint of easily obtaining excellent in-plane uniformity of the polishing rate in the inner region of the surface to be polished. The abrasive grains containing cerium oxide may be an embodiment substantially composed of cerium oxide (an embodiment in which substantially 100% by mass of the abrasive grains is cerium oxide).

The average particle diameter of the abrasive grains may be 50 nm or more, 70 nm or more, 100 nm or more, more than 100 nm, 105 nm or more, 110 nm or more, 115 nm or more, 120 nm or more, 125 nm or more, 130 nm or more, 135 nm or more, or 140 nm or more, from the viewpoint of easily obtaining excellent in-plane uniformity of the polishing rate in the inner region of the surface to be polished. The average particle diameter of the abrasive grains may be 500 nm or less, 300 nm or less, 200 nm or less, 180 nm or less, 150 nm or less, or 140 nm or less, from the viewpoint of easily suppressing the occurrence of polishing scratches. From these viewpoints, the average particle diameter of the abrasive grains may be 50 to 500 nm, 50 to 200 nm, 50 to 150 nm, 70 to 500 nm, 70 to 200 nm, 70 to 150 nm, 100 to 500 nm, 100 to 200 nm, or 100 to 150 nm.

The "average particle diameter of the abrasive grains" means median of the volume distribution measured for an abrasive grain-dispersed slurry sample using a laser diffraction/scattering particle size distribution measuring device, and

can be measured using trade name: Microtrac MT3300EXII manufactured by MicrotracBEL Corp., or the like. For example, a sample is prepared by dispersing the abrasive grains in water and adjusting the content of the abrasive grains so that the content of the abrasive grains is 0.25% by mass based on the total mass of the sample, this sample is set in the measuring device, and then the median of the volume distribution can be measured. In the case of measuring the particle diameter of the abrasive grains in the polishing liquid, a sample is prepared by adjusting the content of the abrasive grains in the polishing liquid so that the content of the abrasive grains is 0.25% by mass based on the total mass of the sample, and the measurement can be performed using this sample by the same method.

The content of the abrasive grains may be in the following range on the basis of the total mass of the polishing liquid from the viewpoint of easily obtaining excellent in-plane uniformity of the polishing rate in the inner region of the surface to be polished. The content of the abrasive grains may be 0.01% by mass or more, 0.05% by mass or more, 0.1% by mass or more, 0.15% by mass or more, 0.2% by mass or more, 0.25% by mass or more, 0.3% by mass or more, 0.35% by mass or more, 0.4% by mass or more, 0.45% by mass or more, or 0.5% by mass or more. The content of the abrasive grains may be 10% by mass or less, 8% by mass or less, 5% by mass or less, 4% by mass or less, 3% by mass or less, 2.5% by mass or less, 2% by mass or less, 1.5% by mass or less, 1% by mass or less, 0.8% by mass or less, 0.6% by mass or less, or 0.5% by mass or less. From these viewpoints, the content of the abrasive grains may be 0.01 to 10% by mass, 0.01 to 5% by mass, 0.01 to 2% by mass, 0.01 to 1% by mass, 0.05 to 10% by mass, 0.05 to 5% by mass, 0.05 to 2% by mass, 0.05 to 1% by mass, 0.1 to 10% by mass, 0.1 to 5% by mass, 0.1 to 2% by mass, or 0.1 to 1% by mass.

(Additive)

[Component (A1): nitrogen-containing hydroxyalkyl compound]

From the viewpoint of obtaining excellent in-plane uniformity of the polishing rate in the inner region on the surface to be polished excluding the outer peripheral part, the additive of the polishing liquid of the first embodiment includes (A1) a compound having two or more nitrogen atoms to which a hydroxyalkyl group is bonded (component (A1)) as the component (A). **In** the component (A1), the hydroxyalkyl group is directly bonded to the nitrogen atom, and the hydroxy group is directly bonded to the alkyl group directly bonded to the nitrogen atom. **In** the component (A1), an alkyl group having no substituent other than a hydroxy group can be used as the hydroxyalkyl group bonded to the nitrogen atom.

From the viewpoint of easily obtaining excellent in-plane uniformity of the polishing rate in the inner region of the surface to be polished, the component (A1) may include a compound having a nitrogen atom to which two hydroxyalkyl groups are bonded, and may include a compound having two or more nitrogen atoms to which two hydroxyalkyl groups are bonded.

From the viewpoint of easily obtaining excellent in-plane uniformity of the polishing rate in the inner region of the surface to be polished, the number of nitrogen atoms in one molecule of the component (Al) may be 2 to 5, 2 to 4, or 2 to 3. From the viewpoint of easily obtaining excellent in-plane uniformity of the polishing rate in the inner region of the surface to be polished, the number of hydroxy groups in one molecule of the component (A1) may be 2 to 6, 2 to 5, 2 to 4, 3 to 6, 3 to 5, 3 to 4, 4 to 6, or 4 to 5.

From the viewpoint of easily obtaining excellent in-plane uniformity of the polishing rate in the inner region of the surface to be polished, the component (A1) may have a hydroxyalkyl group having 1 to 4, 2 to 4, 3 to 4, 1 to 3, 2 to 3, or 1 to 2 carbon atoms as the hydroxyalkyl group bonded to the nitrogen atom. From the viewpoint of easily obtaining excellent in-plane uniformity of the polishing rate in the inner region of the surface to be polished, the component (A1) may have a hydroxyalkyl group having the number of hydroxy groups of 1 to 3 or 1 to 2 as the hydroxyalkyl group bonded to the nitrogen atom.

From the viewpoint of easily obtaining excellent in-plane uniformity of the polishing rate in the inner region of the surface to be polished, the component (A1) may have an alkylene group between two nitrogen atoms to which the hydroxyalkyl group is bonded. From the viewpoint of easily obtaining excellent in-plane uniformity of the polishing rate in the inner region of the surface to be polished, the number of carbon atoms of such an alkylene group may be 1 to 4, 2 to 4, 1 to 3, 2 to 3, or 1 to 2.

From the viewpoint of easily obtaining excellent in-plane uniformity of the polishing rate in the inner region of the surface to be polished, the component (A1) may include a compound represented by General Formula (I) below.

[Chemical Formula 4]

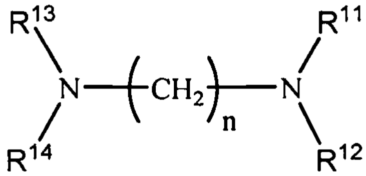

(I)

[In the formula, n is an integer of 1 or more, $R^{11}$, $R^{12}$, $R^{13}$, and $R^{14}$ each independently represent a hydrogen atom or an organic group, one or both of $R^{11}$ and $R^{12}$ are a hydroxyalkyl group, and one or both of $R^{13}$ and $R^{14}$ are a hydroxyalkyl group.]

n may be in the aforementioned range for the number of carbon atoms of the alkylene group between two nitrogen atoms to which the hydroxyalkyl group is bonded. The organic group may be a substituted or unsubstituted alkyl group, may be a hydroxyalkyl group, and may be a group having a nitrogen atom to which a hydroxyalkyl group is bonded. Examples of the substituent of the alkyl group include a hydroxy group, a carboxy group, an amino group, a sulfo group, and a nitro group. In a case where $R^{11}$, $R^{12}$, $R^{13}$, or $R^{14}$ is a hydroxyalkyl group, the number of carbon atoms of the hydroxyalkyl group may be in the aforementioned range for the number of carbon atoms of the hydroxyalkyl group bonded to the nitrogen atom.

Examples of the component (A1) include an ethylenedinitrilotetraethanol (THEED: 2,2',2",2‴-ethylenedinitrilotetraethanol (also known as: N,N,N',N'-Tetrakis(2-hydroxyethyl)ethylenediamine) and the like), an ethylenedinitrilotetrapropanol (EDTP: 1,1',1",1‴-ethylenedinitrilotetra-2-propanol (also known as: N,N,N',N'-Tetrakis(2-hydroxypropyl) ethylenediamine) and the like), and N,N,N',N",N"-pentakis(2-hydroxypropyl)diethylenetriamine. From the viewpoint of easily obtaining excellent in-plane uniformity of the polishing rate in the inner region of the surface to be polished, the component (A1) may include at least one selected from the group consisting of an ethylenedinitrilotetraethanol and an ethylenedinitrilotetrapropanol, may include an ethylenedinitrilotetraethanol, and may include an ethylenedinitrilotetrapropanol. From the viewpoint of easily obtaining excellent in-plane uniformity of the polishing rate in the inner region of the surface to be polished, the component (A1) may include a compound not having a carboxy group.

The molecular weight of the component (A1) may be in the following range from the viewpoint of easily obtaining excellent in-plane uniformity of the polishing rate in the inner region of the surface to be polished. The molecular weight of the component (A1) may be 50 or more, 60 or more, 70 or more, 80 or more, 85 or more, 90 or more, 100 or more, 110 or more, 120 or more, 123 or more, 125 or more, 130 or more, 140 or more, 148 or more, 150 or more, 160 or more, 170 or more, 180 or more, 200 or more, 210 or more, 230 or more, 250 or more, more than 250, or 280 or more. The molecular weight of the component (A1) may be 1000 or less, less than 1000, 900 or less, 800 or less, 700 or less, 600 or less, 500 or less, 400 or less, 350 or less, 300 or less, 280 or less, 250 or less, less than 250, or 240 or less. From these viewpoints, the molecular weight of the component (A1) may be 50 to 1000, 50 to 500, 50 to 300, 50 to 250, 200 to 1000, 200 to 500, 200 to 300, 200 to 250, 250 to 1000, 250 to 500, or 250 to 300.

As the content of the component (A1), the content of the ethylenedinitrilotetraethanol, or the content of the ethylenedinitrilotetrapropanol, a content A11 may be in the following range on the basis of the total mass of the polishing liquid from the viewpoint of easily obtaining excellent in-plane uniformity of the polishing rate in the inner region of the surface to be polished. The content A11 may be 0.001% by mass or more, 0.003% by mass or more, 0.005% by mass or more, 0.008% by mass or more, 0.01% by mass or more, 0.012% by mass or more, 0.015% by mass or more, 0.018% by mass or more, or 0.02% by mass or more. The content A11 may be 5% by mass or less, 3% by mass or less, 1% by mass or less, 0.5% by mass or less, 0.4% by mass or less, 0.3% by mass or less, 0.2% by mass or less, 0.15% by mass or less, 0.1% by mass or less, 0.08% by mass or less, 0.06% by mass or less, 0.05% by mass or less, 0.045% by mass or less, 0.04% by mass or less, 0.035% by mass or less, 0.03% by mass or less, 0.025% by mass or less, or 0.02% by mass or less. From these viewpoints, the content A11 may be 0.001 to 5% by mass, 0.001 to 1% by mass, 0.001 to 0.1% by mass, 0.005 to 5% by mass, 0.005 to 1% by mass, 0.005 to 0.1% by mass, 0.01 to 5% by mass, 0.01 to 1% by mass, or 0.01 to 0.1% by mass.

As the content of the component (A1), the content of the ethylenedinitrilotetraethanol, or the content of the ethylenedinitrilotetrapropanol, a content A12 may be in the following range with respect to 100 parts by mass of the abrasive grains from the viewpoint of easily obtaining excellent in-plane uniformity of the polishing rate in the inner region of the surface to be polished. The content A12 may be 0.1 parts by mass or more, 0.5 parts by mass or more, 1 part by mass or more, 1.5 parts by mass or more, 2 parts by mass or more, 2.5 parts by mass or more, 3 parts by mass or more, 3.5 parts by mass or more, or 4 parts by mass or more. The content A12 may be 100 parts by mass or less, less than 100 parts by mass, 80 parts by mass or less, 60 parts by mass or less, 50 parts by mass or less, 40 parts by mass or less, 30 parts by mass or less, 20 parts by mass or less, 10 parts by mass or less, 8 parts by mass or less, 6 parts by mass or less, 5 parts by mass or less, or 4 parts by mass or less. From these viewpoints, the content A12 may be 0.1 to 100 parts by mass, 0.1 to 50 parts by mass, 0.1 to 10 parts by mass, 0.5 to 100 parts by mass, 0.5 to 50 parts by mass, 0.5 to 10 parts by mass, 1 to 100 parts by

mass, 1 to 50 parts by mass, or 1 to 10 parts by mass.

[Component (A2): polyglycerol)]

From the viewpoint of obtaining excellent in-plane uniformity of the polishing rate in the inner region on the surface to be polished excluding the outer peripheral part, the additive of the polishing liquid of the second embodiment includes (A2) a polyglycerol (component (A2)) as the component (A).

The weight average molecular weight of the component (A2) may be 350 or more, 400 or more, 450 or more, 500 or more, 550 or more, 600 or more, 650 or more, 700 or more, or 750 or more, from the viewpoint of easily obtaining excellent in-plane uniformity of the polishing rate in the inner region of the surface to be polished. The weight average molecular weight of the component (A2) may be 800 or more, 900 or more, 1000 or more, 1500 or more, 2000 or more, or 2500 or more. The weight average molecular weight of the component (A2) may be 5000 or less, 4500 or less, 4000 or less, 3500 or less, 3000 or less, 2500 or less, 2400 or less, 2200 or less, 2000 or less, less than 2000, 1800 or less, 1600 or less, 1500 or less, 1400 or less, 1200 or less, 1000 or less, less than 1000, 950 or less, 900 or less, 850 or less, 800 or less, or 750 or less, from the viewpoint of easily obtaining excellent in-plane uniformity of the polishing rate in the inner region of the surface to be polished. From these viewpoints, the weight average molecular weight of the component (A2) may be 350 to 5000, 350 to 3500, 350 to 1000, 500 to 5000, 500 to 3500, 500 to 1000, 700 to 5000, 700 to 3500, or 700 to 1000.

The weight average molecular weight of the component (A2) can be measured, for example, using gel permeation chromatography (GPC) under the following conditions.

[Conditions]

Sample: 20 μL
Standard polyethylene glycol: Standard polyethylene glycol (molecular weight: 106, 194, 440, 600, 1470, 4100, 7100, 10300, 12600, and 23000) manufactured by Polymer Laboratories Co., Ltd.
Detector: RI-monitor, trade name "Syodex-RI SE-61" manufactured by Showa Denko K.K.
Pump: trade name "L-6000" manufactured by Hitachi, Ltd.
Column: trade names "GS-220 HQ" and "GS-620 HQ" manufactured by Showa Denko K.K. are connected in this order and used.
Eluent: 0.4 mol/L sodium chloride aqueous solution
Measurement temperature: 30°C
Flow rate: 1.00 mL/min
Measurement time: 45 min

The hydroxyl value of the component (A2) may be 600 mgKOH/g or more, 650 mgKOH/g or more, 700 mgKOH/g or more, 750 mgKOH/g or more, 800 mgKOH/g or more, 830 mgKOH/g or more, 850 mgKOH/g or more, 870 mgKOH/g or more, 880 mgKOH/g or more, or 900 mgKOH/g or more, from the viewpoint of easily obtaining excellent in-plane uniformity of the polishing rate in the inner region of the surface to be polished. The hydroxyl value of the component (A2) may be 1500 mgKOH/g or less, 1200 mgKOH/g or less, 1000 mgKOH/g or less, 980 mgKOH/g or less, 960 mgKOH/g or less, 950 mgKOH/g or less, 930 mgKOH/g or less, 910 mgKOH/g or less, or 900 mgKOH/g or less, from the viewpoint of easily obtaining excellent in-plane uniformity of the polishing rate in the inner region of the surface to be polished. The hydroxyl value of the component (A2) may be 880 mgKOH/g or less, 870 mgKOH/g or less, 850 mgKOH/g or less, 830 mgKOH/g or less, or 800 mgKOH/g or less. From these viewpoints, the hydroxyl value of the component (A2) may be 600 to 1500 mgKOH/g, 600 to 1000 mgKOH/g, 600 to 950 mgKOH/g, 700 to 1500 mgKOH/g, 700 to 1000 mgKOH/g, 700 to 950 mgKOH/g, 800 to 1500 mgKOH/g, 800 to 1000 mgKOH/g, or 800 to 950 mgKOH/g. The hydroxyl value can be calculated from the following formula. As the degree of polymerization in the following formula, the average degree of polymerization can be used.

Hydroxyl value = 56110 × (degree of polymerization + 2)/(74 × degree of polymerization + 18)

The average degree of polymerization of glycerol in the component (A2) may be in the following range. The average degree of polymerization may be 5 or more, 6 or more, 8 or more, or 10 or more, from the viewpoint of easily obtaining excellent in-plane uniformity of the polishing rate in the inner region of the surface to be polished. The average degree of polymerization may be 12 or more, 15 or more, 20 or more, 30 or more, or 40 or more. The average degree of polymerization may be 50 or less, 40 or less, 30 or less, 20 or less, 15 or less, 12 or less, or 10 or less, from the viewpoint of

easily obtaining excellent in-plane uniformity of the polishing rate in the inner region of the surface to be polished. From these viewpoints, the average degree of polymerization may be 5 to 50, 5 to 40, 5 to 30, 8 to 20, 8 to 12, 10 to 30, or 5 to 10.

The content of the component (A2) may be in the following range on the basis of the total mass of the polishing liquid from the viewpoint of easily obtaining excellent in-plane uniformity of the polishing rate in the inner region of the surface to be polished. The content of the component (A2) may be 0.001% by mass or more, 0.005% by mass or more, 0.01% by mass or more, 0.03% by mass or more, 0.05% by mass or more, 0.08% by mass or more, 0.1% by mass or more, 0.12% by mass or more, 0.15% by mass or more, 0.18% by mass or more, or 0.2% by mass or more. The content of the component (A2) may be 10% by mass or less, 8% by mass or less, 5% by mass or less, 3% by mass or less, 2% by mass or less, 1.5% by mass or less, 1% by mass or less, 0.8% by mass or less, 0.5% by mass or less, 0.45% by mass or less, 0.4% by mass or less, 0.35% by mass or less, 0.3% by mass or less, 0.25% by mass or less, or 0.2% by mass or less. From these viewpoints, the content of the component (A2) may be 0.001 to 10% by mass, 0.001 to 5% by mass, 0.001 to 1% by mass, 0.001 to 0.5% by mass, 0.01 to 10% by mass, 0.01 to 5% by mass, 0.01 to 1% by mass, 0.01 to 0.5% by mass, 0.05 to 10% by mass, 0.05 to 5% by mass, 0.05 to 1% by mass, 0.05 to 0.5% by mass, 0.1 to 10% by mass, 0.1 to 5% by mass, 0.1 to 1% by mass, or 0.1 to 0.5% by mass.

The content of the component (A2) may be in the following range with respect to 100 parts by mass of the abrasive grains from the viewpoint of easily obtaining excellent in-plane uniformity of the polishing rate in the inner region of the surface to be polished. The content of the component (A2) may be 1 part by mass or more, 5 parts by mass or more, 10 parts by mass or more, 15 parts by mass or more, 20 parts by mass or more, 25 parts by mass or more, 30 parts by mass or more, 35 parts by mass or more, or 40 parts by mass or more. The content of the component (A2) may be 500 parts by mass or less, 300 parts by mass or less, 200 parts by mass or less, 150 parts by mass or less, 100 parts by mass or less, less than 100 parts by mass, 90 parts by mass or less, 80 parts by mass or less, 70 parts by mass or less, 65 parts by mass or less, 60 parts by mass or less, 55 parts by mass or less, 50 parts by mass or less, 45 parts by mass or less, or 40 parts by mass or less. From these viewpoints, the content of the component (A2) may be 1 to 500 parts by mass, 1 to 200 parts by mass, 1 to 50 parts by mass, 10 to 500 parts by mass, 10 to 200 parts by mass, 10 to 50 parts by mass, 30 to 500 parts by mass, 30 to 200 parts by mass, or 30 to 50 parts by mass.

[Component (B): 4-pyrone-based compound]

From the viewpoint of obtaining excellent in-plane uniformity of the polishing rate in the inner region on the surface to be polished excluding the outer peripheral part, the additive of the polishing liquid of the present embodiment includes a 4-pyrone-based compound represented by General Formula (1) below (hereinafter, simply referred to as "4-pyrone-based compound" in some cases) as the component (B).

[Chemical Formula 5]

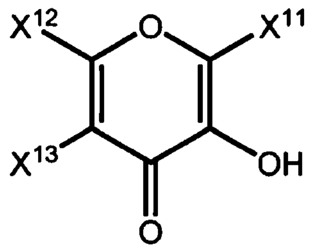

(1)

[In the formula, $X^{11}$, $X^{12}$, and $X^{13}$ are each independently a hydrogen atom or a monovalent substituent.]

The 4-pyrone-based compound is a compound having a structure in which a hydroxy group is bonded to a carbon atom adjacent to a carbon atom of a carbonyl group. The "4-pyrone-based compound" is a heterocyclic compound having a γ-pyrone ring (6-membered ring) which has an oxy group and a carbonyl group and in which the carbonyl group is located at the 4th position with respect to the oxy group. In the 4-pyrone-based compound, the hydroxy group is bonded to the carbon atom adjacent to the carboxy group in this γ-pyrone ring, and other carbon atoms may be substituted with substituents other than hydrogen atoms.

In General Formula (1), $X^{11}$, $X^{12}$, and $X^{13}$ are each independently a hydrogen atom or a monovalent substituent. Examples of the monovalent substituent include an aldehyde group, a hydroxy group, a carboxy group, a carboxylate group, a sulfonic acid group, a phosphoric acid group, a bromine atom, a chlorine atom, an iodine atom, a fluorine atom, a nitro group, a hydrazine group, an alkyl group (for example, an alkyl group having 1 to 8 carbon atoms), an aryl group (for example, an aryl group having 6 to 12 carbon atoms), and an alkenyl group (for example, an alkenyl group having 1 to 8 carbon atoms). The alkyl group, the aryl group, and the alkenyl group may be substituted with OH, COOH, Br, Cl, I, $NO_2$, or the like. In the case of having a monovalent substituent as $X^{11}$, $X^{12}$, and $X^{13}$, the substituent may be bonded to a carbon

atom adjacent to an oxy group, that is, $X^{11}$ and $X^{12}$ may be substituents. At least two of $X^{11}$, $X^{12}$, and $X^{13}$ may be a hydrogen atom.

From the viewpoint of easily obtaining excellent in-plane uniformity of the polishing rate in the inner region of the surface to be polished, the 4-pyrone-based compound may include at least one selected from the group consisting of 3-hydroxy-2-methyl-4-pyrone (also known as: 3-hydroxy-2-methyl-4H-pyran-4-one, maltol), 5-hydroxy-2-(hydroxymethyl)-4-pyrone (also known as: 5-hydroxy-2-(hydroxymethyl)-4H-pyran-4-one, kojic acid), and 2-ethyl-3-hydroxy-4-pyrone (also known as: 2-ethyl-3-hydroxy-4H-pyran-4-one), and may include 3-hydroxy-2-methyl-4-pyrone.

The content of the 4-pyrone-based compound may be in the following range on the basis of the total mass of the polishing liquid from the viewpoint of easily obtaining excellent in-plane uniformity of the polishing rate in the inner region of the surface to be polished. The content of the 4-pyrone-based compound may be 0.001% by mass or more, 0.005% by mass or more, 0.01% by mass or more, 0.015% by mass or more, 0.02% by mass or more, 0.025% by mass or more, 0.03% by mass or more, or 0.034% by mass or more. The content of the 4-pyrone-based compound may be 5% by mass or less, 3% by mass or less, 1% by mass or less, 0.8% by mass or less, 0.5% by mass or less, 0.3% by mass or less, 0.2% by mass or less, 0.15% by mass or less, 0.1% by mass or less, 0.08% by mass or less, 0.05% by mass or less, 0.04% by mass or less, or 0.035% by mass or less. From these viewpoints, the content of the 4-pyrone-based compound may be 0.001 to 5% by mass, 0.001 to 1% by mass, 0.001 to 0.1% by mass, 0.01 to 5% by mass, 0.01 to 1% by mass, 0.01 to 0.1% by mass, 0.03 to 5% by mass, 0.03 to 1% by mass, or 0.03 to 0.1% by mass.

The content of the 4-pyrone-based compound may be in the following range with respect to 100 parts by mass of the abrasive grains from the viewpoint of easily obtaining excellent in-plane uniformity of the polishing rate in the inner region of the surface to be polished. The content of the 4-pyrone-based compound may be 0.1 parts by mass or more, 0.5 parts by mass or more, 1 part by mass or more, 2 parts by mass or more, 3 parts by mass or more, 4 parts by mass or more, 5 parts by mass or more, or 6 parts by mass or more. The content of the 4-pyrone-based compound may be 100 parts by mass or less, less than 100 parts by mass, 80 parts by mass or less, 60 parts by mass or less, 50 parts by mass or less, 40 parts by mass or less, 30 parts by mass or less, 25 parts by mass or less, 20 parts by mass or less, 15 parts by mass or less, 10 parts by mass or less, or 8 parts by mass or less. From these viewpoints, the content of the 4-pyrone-based compound may be 0.1 to 100 parts by mass, 0.1 to 50 parts by mass, 0.1 to 10 parts by mass, 1 to 100 parts by mass, 1 to 50 parts by mass, 1 to 10 parts by mass, 5 to 100 parts by mass, 5 to 50 parts by mass, or 5 to 10 parts by mass.

The content of the 4-pyrone-based compound may be in the following range with respect to 100 parts by mass of the component (A1) from the viewpoint of easily obtaining excellent in-plane uniformity of the polishing rate in the inner region of the surface to be polished. The content of the 4-pyrone-based compound may be 10 parts by mass or more, 30 parts by mass or more, 50 parts by mass or more, 80 parts by mass or more, 100 parts by mass or more, more than 100 parts by mass, 120 parts by mass or more, or 150 parts by mass or more. The content of the 4-pyrone-based compound may be 1000 parts by mass or less, 800 parts by mass or less, 600 parts by mass or less, 500 parts by mass or less, 400 parts by mass or less, 350 parts by mass or less, 300 parts by mass or less, 250 parts by mass or less, 200 parts by mass or less, or 180 parts by mass or less. From these viewpoints, the content of the 4-pyrone-based compound may be 10 to 1000 parts by mass, 10 to 500 parts by mass, 10 to 200 parts by mass, 50 to 1000 parts by mass, 50 to 500 parts by mass, 50 to 200 parts by mass, 100 to 1000 parts by mass, 100 to 500 parts by mass, or 100 to 200 parts by mass.

The content of the 4-pyrone-based compound may be in the following range with respect to 100 parts by mass of the component (A2) from the viewpoint of easily obtaining excellent in-plane uniformity of the polishing rate in the inner region of the surface to be polished. The content of the 4-pyrone-based compound may be 0.1 parts by mass or more, 0.5 parts by mass or more, 1 part by mass or more, 3 parts by mass or more, 5 parts by mass or more, 8 parts by mass or more, 10 parts by mass or more, 12 parts by mass or more, or 15 parts by mass or more. The content of the 4-pyrone-based compound may be 100 parts by mass or less, less than 100 parts by mass, 80 parts by mass or less, 60 parts by mass or less, 50 parts by mass or less, 40 parts by mass or less, 30 parts by mass or less, 25 parts by mass or less, 20 parts by mass or less, or 18 parts by mass or less. From these viewpoints, the content of the 4-pyrone-based compound may be 0.1 to 100 parts by mass, 0.1 to 50 parts by mass, 0.1 to 20 parts by mass, 1 to 100 parts by mass, 1 to 50 parts by mass, 1 to 20 parts by mass, 10 to 100 parts by mass, 10 to 50 parts by mass, or 10 to 20 parts by mass.

[Saturated monocarboxylic acid]

The additive of the polishing liquid of the present embodiment may include a saturated monocarboxylic acid. By using the saturated monocarboxylic acid, it is easy to adjust a polishing rate ratio (for example, silicon oxide/silicon nitride) while obtaining favorable dispersibility of the abrasive grains.

Examples of the saturated monocarboxylic acid include acetic acid, propionic acid, butyric acid, isobutyric acid, valeric acid, isovaleric acid, pivalic acid, hydroangelic acid, caproic acid, 2-methylpentanoic acid, 4-methylpentanoic acid, 2,3-dimethylbutanoic acid, 2-ethylbutanoic acid, 2,2-dimethylbutanoic acid, and 3,3-dimethylbutanoic acid. The saturated monocarboxylic acid may include an aliphatic carboxylic acid from the viewpoint of easily obtaining the aforementioned effect of addition of the saturated monocarboxylic acid. From the viewpoint of easily obtaining the aforementioned effect of

addition of the saturated monocarboxylic acid, the saturated monocarboxylic acid may include a saturated monocarboxylic acid having 2 to 6 carbon atoms, and may include at least one selected from the group consisting of acetic acid and propionic acid.

The content of the saturated monocarboxylic acid may be in the following range on the basis of the total mass of the polishing liquid from the viewpoint of easily obtaining the aforementioned effect of addition of the saturated monocarboxylic acid. The content of the saturated monocarboxylic acid may be 0.001% by mass or more, 0.005% by mass or more, 0.01% by mass or more, 0.03% by mass or more, 0.05% by mass or more, 0.08% by mass or more, or 0.09% by mass or more. The content of the saturated monocarboxylic acid may be 5% by mass or less, 3% by mass or less, 1% by mass or less, 0.8% by mass or less, 0.5% by mass or less, 0.4% by mass or less, 0.3% by mass or less, 0.2% by mass or less, or 0.1% by mass or less. From these viewpoints, the content of the saturated monocarboxylic acid may be 0.001 to 5% by mass, 0.001 to 1% by mass, 0.001 to 0.5% by mass, 0.01 to 5% by mass, 0.01 to 1% by mass, 0.01 to 0.5% by mass, 0.05 to 5% by mass, 0.05 to 1% by mass, or 0.05 to 0.5% by mass.

[Other additive]

The additive of the polishing liquid of the present embodiment may further include other component (component not corresponding to each component mentioned above) according to desired characteristics. Examples of such a component include a nonionic polymer; a cationic compound; a pH adjusting agent described below; a polar solvent such as ethanol and acetone; and a cyclic monocarboxylic acid.

The polishing liquid of the present embodiment may contain a compound a having a molecular weight of 100000 or less and having four or more hydroxy groups, or may not contain the compound a. The polishing liquid of the present embodiment may contain a compound b having four or more amino groups, or may not contain the compound b. The content of the compound b may be 0.001% by mass or less, less than 0.001% by mass, 0.0001% by mass or less, 0.00001% by mass or less, or substantially 0% by mass, on the basis of the total mass of the polishing liquid. The mass ratio of the content of the compound a with respect to the content of the compound b (compound a/compound b) may be 0.10 or less or less than 0.10.

(Water)

Water is not particularly limited, and may include at least one selected from the group consisting of deionized water, ion-exchange water, and ultrapure water.

(pH)

The pH of the polishing liquid of the present embodiment may be in the following range. The pH may be 10.00 or less, less than 10.00, 9.50 or less, 9.00 or less, less than 9.00, 8.50 or less, 8.00 or less, less than 8.00, 7.50 or less, 7.00 or less, less than 7.00, 6.50 or less, 6.00 or less, less than 6.00, 5.50 or less, less than 5.50, 5.00 or less, less than 5.00, 4.50 or less, 4.30 or less, 4.20 or less, 4.10 or less, 4.00 or less, less than 4.00, 3.98 or less, or 3.95 or less, from the viewpoint of easily obtaining excellent in-plane uniformity of the polishing rate in the inner region of the surface to be polished. The pH may be 3.92 or less, 3.90 or less, 3.85 or less, 3.80 or less, 3.70 or less, 3.60 or less, or 3.50 or less. The pH may be 1.00 or more, more than 1.00, 1.50 or more, 2.00 or more, more than 2.00, 2.50 or more, 3.00 or more, more than 3.00, 3.50 or more, 3.60 or more, 3.70 or more, 3.80 or more, 3.85 or more, 3.90 or more, 3.92 or more, or 3.95 or more, from the viewpoint of easily obtaining excellent in-plane uniformity of the polishing rate in the inner region of the surface to be polished. From these viewpoints, the pH may be 1.00 to 10.00, 1.00 to 6.00, 1.00 to 5.00, 2.00 to 10.00, 2.00 to 6.00, 2.00 to 5.00, 3.00 to 10.00, 3.00 to 6.00, or 3.00 to 5.00. The pH can be measured by a method described in Examples.

Since the pH of the polishing liquid can vary depending on the type of a compound used as an additive, a pH adjusting agent may be used for adjusting the pH in the above range. The pH adjusting agent is not particularly limited, and examples thereof include acids such as nitric acid, sulfuric acid, hydrochloric acid, phosphoric acid, and boric acid; and bases such as sodium hydroxide, ammonia (for example, ammonia water), potassium hydroxide, and calcium hydroxide. The aforementioned additive such as a saturated monocarboxylic acid may be used for pH adjustment. From the viewpoint of improving the productivity, a polishing liquid is prepared without using a pH adjusting agent, and this polishing liquid may be applied directly to polishing.

<Preparation method and usage method of polishing liquid>

The polishing liquid of the present embodiment can be categorized as (a) a normal type, (b) a concentrated type, (c) a multiple-liquid type (for example, two-liquid type; polishing liquid set), and the like, and the preparation methods and the usage methods differ depending on the type.

The (a) normal type is a polishing liquid that can be used directly without pretreatment such as dilution at the time of polishing. The (a) normal type can be obtained by dispersing or dissolving the abrasive grains and the additive in water.

The (b) concentrated type is a polishing liquid in which the constituent components are more concentrated than in the (a) normal type, taking into consideration the convenience of storage or transportation. The (b) concentrated type is diluted with water immediately before use to the desired contents of the constituent components.

The (c) multiple-liquid type is a polishing liquid that, during storage or transportation, is kept as a state where the constituent components are separated into multiple liquids (for example, a state of being separated into a first liquid containing certain component and a second liquid containing other component), these liquids being mixed and used at the time of use. Components to be contained in each liquid are any components.

The (c) multiple-liquid type is, for example, a polishing liquid set for obtaining a polishing liquid by mixing a first liquid (slurry) and a second liquid (additive liquid). For example, in the (c) multiple-liquid type (polishing liquid set), the constituent components of the polishing liquid are stored separately in the first liquid and the second liquid, the first liquid contains the abrasive grains and water, and the second liquid contains at least one of the additive including the component (A) and component (B), and water. In a first embodiment of the (c) multiple-liquid type, the first liquid contains the abrasive grains and water, and the second liquid contains the component (A), the component (B), and water. In a second embodiment of the (c) multiple-liquid type, the first liquid contains the abrasive grains, the component (A), and water, and the second liquid contains the component (B) and water. In a third embodiment of the (c) multiple-liquid type, the first liquid contains the abrasive grains, the component (B), and water, and the second liquid contains the component (A) and water. The first liquid and the second liquid may contain other component to be used as necessary. The constituent components of the polishing liquid may be divided into three or more liquids.

The polishing liquid of the (c) multiple-liquid type is useful in the case of combinations of components that, when mixed, tend to degrade the polishing properties in a relatively short period of time by the aggregation of the abrasive grains, or the like. From the viewpoint of reducing storage and transportation costs, at least one of respective liquids (such as the first liquid or the second liquid) may be a concentrated type. In this case, when the polishing liquid is used, each liquid and water may be mixed.

<Polishing method>

A polishing method of the present embodiment includes a polishing step of polishing a surface to be polished of a member to be polished by using the polishing liquid of the present embodiment. The polishing liquid used in the polishing step may be a polishing liquid obtained by mixing a plurality of liquids (for example, the first liquid and the second liquid) of the aforementioned polishing liquid set. That is, the polishing method of the present embodiment may include a polishing step of polishing a surface to be polished of a member to be polished by using a polishing liquid obtained by mixing a plurality of liquids (for example, the first liquid and the second liquid) of the aforementioned polishing liquid set.

The polishing step may be a step of supplying the polishing liquid of the present embodiment between a member to be polished and a polishing member (a member for polishing: a polishing pad or the like) and polishing a surface to be polished of the member to be polished by the polishing member. The polishing method of the present embodiment can be used to polish a silicon oxide film of a member to be polished having the silicon oxide film on a surface thereof. That is, a surface to be polished may contain silicon oxide, and the polishing step may be a step of supplying the polishing liquid of the present embodiment between a silicon oxide film in a member to be polished having the silicon oxide film on a surface thereof and a polishing member and polishing the silicon oxide film by the polishing member. The polishing step may be a step of polishing an inner region remaining on a surface to be polished of a member to be polished excluding an outer peripheral part, and may be a step of polishing an inner region remaining on a surface to be polished of a silicon oxide film excluding an outer peripheral part.

<Manufacturing method and the like>

A method for manufacturing a component of the present embodiment includes a component manufacturing step of obtaining a component by using a polished member polished by the polishing method of the present embodiment. A component of the present embodiment is a component obtained by the method for manufacturing a component of the present embodiment. The component of the present embodiment is not particularly limited, may be an electronic component (for example, a semiconductor component such as a semiconductor package), may be a wafer (for example, a semiconductor wafer), and may be a chip (for example, a semiconductor chip). As an embodiment of the method for manufacturing a component of the present embodiment, in a method for manufacturing an electronic component of the present embodiment, an electronic component is obtained by using a polished member polished by the polishing method of the present embodiment. As an embodiment of the method for manufacturing a component of the present embodiment, in a method for manufacturing a semiconductor component of the present embodiment, a semiconductor component (for example, a semiconductor package) is obtained by using a polished member polished by the polishing method of the

present embodiment. The method for manufacturing a component of the present embodiment may include a polishing step of polishing a member to be polished by the polishing method of the present embodiment before the component manufacturing step.

The method for manufacturing a component of the present embodiment may include, as an embodiment of the component manufacturing step, an individually dividing step of individually dividing a polished member polished by the polishing method of the present embodiment. The individually dividing step may be, for example, a step of dicing a wafer (for example, a semiconductor wafer) polished by the polishing method of the present embodiment to obtain chips (for example, semiconductor chips). As an embodiment of the method for manufacturing a component of the present embodiment, the method for manufacturing an electronic component of the present embodiment may include a step of obtaining an electronic component (for example, a semiconductor component) by individually dividing a polished member polished by the polishing method of the present embodiment. As an embodiment of the method for manufacturing a component of the present embodiment, the method for manufacturing a semiconductor component of the present embodiment may include a step of obtaining a semiconductor component (for example, a semiconductor package) by individually dividing a polished member polished by the polishing method of the present embodiment.

The method for manufacturing a component of the present embodiment may include, as an embodiment of the component manufacturing step, a connecting step of connecting (for example, electrically connecting) a polished member polished by the polishing method of the present embodiment to other body to be connected. The body to be connected that is connected to the polished member polished by the polishing method of the present embodiment is not particularly limited, may be a polished member polished by the polishing method of the present embodiment, and may be a body to be connected different from the polished member polished by the polishing method of the present embodiment. In the connecting step, the polished member and the body to be connected may be directly connected to each other (connected in a state where the polished member and the body to be connected are in contact with each other), and the polished member and the body to be connected may be connected via other member (such as a conductive member). The connecting step can be performed before the individually dividing step, after the individually dividing step, or before and after the individually dividing step.

The connecting step may be a step of connecting a polished surface of a polished member polished by the polishing method of the present embodiment to a body to be connected, and may be a step of connecting a connection surface of a polished member polished by the polishing method of the present embodiment to a connection surface of a body to be connected. The connection surface of the polished member may be a polished surface polished by the polishing method of the present embodiment. A connection body having the polished member and the connected body can be obtained by the connecting step. In the connecting step, in a case where the connection surface of the polished member has a metal portion, the body to be connected may be connected to the metal portion. In the connecting step, in a case where the connection surface of the polished member has a metal portion and the connection surface of the body to be connected has a metal portion, the metal portions may be connected to each other. The metal portion may contain, for example, copper.

A device (for example, an electronic device such as a semiconductor device) of the present embodiment has at least one selected from the group consisting of the polished member polished by the polishing method of the present embodiment and the component of the present embodiment.

## Examples

Hereinafter, the present disclosure will be further specifically described by means of Examples; however, the present disclosure is not limited to these Examples.

<Preparation of cerium oxide powder>

40 kg of cerium carbonate hydrate was divided and placed in ten of alumina containers, respectively, and fired at 830°C for 2 hours in air to obtain 20 kg of yellowish-white powder in total. The phase identification of this powder was performed by an X-ray diffraction method, and it was confirmed that this powder contained polycrystalline cerium oxide. The particle diameter of the powder obtained by firing was observed with a SEM and was found to be in a range of 20 to 100 μm. Next, 20 kg of the cerium oxide powder was subjected to dry pulverization using a jet mill to obtain a cerium oxide powder. The specific surface area of the cerium oxide powder after pulverization was 9.4 $m^2/g$. The measurement of the specific surface area was performed by the BET method.

<Preparation of slurry>

15.0 kg of the cerium oxide powder obtained above and 84.5 kg of deionized water were placed in a container and mixed. Next, 0.03 kg of acetic acid was added and then stirred for 10 minutes, thereby obtaining a cerium oxide mixed

liquid. This cerium oxide mixed liquid was sent to another container over 30 minutes. Meanwhile, in the sending pipe, the cerium oxide mixed liquid was irradiated with ultrasonic wave at an ultrasonic wave frequency of 400 kHz.

A 800 g ± 8 g portion of the cerium oxide mixed liquid conveyed with the ultrasonic irradiation was divided into each of four 1000 mL polyethylene containers. The cerium oxide mixed liquid in each container was subjected to centrifugal separation for 20 minutes under conditions with an outer peripheral centrifugal force of 500 G. After centrifugal separation, the supernatant fraction in the container was collected to obtain a slurry. The slurry contained about 10.0% by mass of cerium oxide particles (abrasive grains) based on the total mass.

The slurry was diluted with pure water so that the content of the abrasive grains (basis: the total mass of the sample) was 0.25% by mass, thereby obtaining a sample for particle diameter measurement. For this sample, the average particle diameter of the abrasive grains was measured using a laser diffraction/scattering particle size distribution measuring device (manufactured by MicrotracBEL Corp., trade name: Microtrac MT3300EXII), and as a result, the average particle diameter thereof was 140 nm.

<Preparation of polishing liquid>

The aforementioned slurry, each component of Table 1, propionic acid, and deionized water were mixed to obtain a polishing liquid (polishing liquid for CMP). On the basis of the total amount of the polishing liquid, the content of the abrasive grains was 0.5% by mass, the content of the component A1 (EDTP or THEED) was 0.02% by mass (Examples 1 and 2 and Comparative Examples 1 and 2), the content of the component A2 (polyglycerol) was 0.2% by mass (Examples 3 and 4 and Comparative Example 2), the content of the component B (maltol) was 0.034% by mass (Examples 1 to 4 and Comparative Example 3), the content of the propionic acid was 0.09% by mass, and the content of the acetic acid (acetic acid mixed when the aforementioned slurry was prepared) was 0.001% by mass.

Details of each component in the table are as follows.

EDTP: 1,1',1",1‴-Ethylenedinitrilotetra-2-propanol
THEED: 2,2',2",2‴-Ethylenedinitrilotetraethanol
Polyglycerol P1: manufactured by Sakamoto Yakuhin Kogyo Co., Ltd., trade name Polyglycerol #750, decamer, weight average molecular weight: 750, hydroxyl value: 900 mgKOH/g
Polyglycerol P2: manufactured by Daicel Corporation, trade name PGL XPW, 40-mer, weight average molecular weight: $2.9 \times 10^3$, hydroxyl value: 791 mgKOH/g

<pH measurement>

(pH of polishing liquid)

The pH of the polishing liquid was measured under the following conditions. The results are shown in Table 1.

Measurement temperature: 25°C
Measuring apparatus: trade name: Model (D-71) manufactured by HORIBA, Ltd.

Measurement method: calibrating the pH meter by three points using a pH standard solution (pH: 4.01) of a phthalate, a pH standard solution (pH: 6.86) of a neutral phosphate, and a pH standard solution (pH: 9.18) of a borate as pH standard solutions, then putting an electrode of the pH meter in the polishing liquid, and measuring the pH with the above-described measuring apparatus at the time after 2 min or more elapsed and the pH became stable.

<Evaluation of polishing properties>

(Preparation of wafer for evaluation)

As a blanket wafer, a wafer with no pattern having a silicon oxide film (TEOS oxide film, initial film thickness: 1000 nm) on a surface thereof and having a diameter of 300 mm (shape: circular) was prepared.

(Polishing procedure)

The aforementioned wafer for evaluation was polished using a polishing apparatus (manufactured by EBARA CORPORATION, trade name: F-REX300X). The aforementioned wafer for evaluation was set in a holder having an adsorption pad. A polishing pad (manufactured by DuPont, trade name: IK4250H) made of a porous urethane resin was attached to a polishing platen having a diameter of 700 mm.

The aforementioned holder was placed on the polishing pad with the surface to be polished of the aforementioned wafer for evaluation facing downward. The retainer ring pressure and the membrane pressure were set to 34 kPa and 21 kPa, respectively.

Then, while adding dropwise the aforementioned polishing liquid onto the polishing pad attached to the aforementioned polishing platen at a flow rate of 250 mL/min, the polishing platen and the wafer for evaluation were rotated at 93 $min^{-1}$ and 87 $min^{-1}$, respectively, for polishing the surface to be polished. The polishing time was 20 seconds. Subsequently, the polished wafer for evaluation was thoroughly washed with pure water using a polyvinyl alcohol brush and then dried.

(Evaluation of in-plane uniformity)

A light interference type film thickness measuring apparatus (manufactured by Nova Ltd., trade name: nova i500) was used to measure a change amount in film thickness of a plurality of measuring points of the inner region remaining on the silicon oxide film excluding the outer peripheral part with 3 mm from the outer periphery, and the polishing rate of each measuring point was obtained. The measuring points were locations at -147 mm, -145 mm, -140 mm, -135 mm, ··· (5 mm intervals) ···, -10 mm, and -5 mm from the center point, the center point, and locations at +5 mm, +10 mm, ··· (5 mm intervals) ···, +135 mm, +140 mm, +145 mm, and +147 mm from the center point, in the diameter direction passing through the center point of the inner region. After calculating the average value and standard deviation of the polishing rate, the numerical value (unit: %) of "NU = standard deviation/average value" was calculated. As an index of in-plane uniformity, the numerical value obtained by dividing NU of each Example and each Comparative Example by NU of Comparative Example 3 is shown in Table 1.

[Table 1]

| | Component A1 | Component A2 (polyglycerol) | Component B (maltol) | pH | In-plane uniformity |
|---|---|---|---|---|---|
| Example 1 | EDTP | Not used | Used | 3.95 | 0.51 |
| Example 2 | THEED | Not used | Used | 3.96 | 0.60 |
| Example 3 | Not used | P1 | Used | 3.47 | 0.72 |
| Example 4 | Not used | P2 | Used | 3.43 | 0.85 |
| Comparative Example 1 | EDTP | Not used | Not used | 3.89 | 0.96 |
| Comparative Example 2 | EDTP | P1 | Not used | 3.92 | 0.98 |
| Comparative Example 3 | Not used | Not used | Used | 3.48 | 1.00 |

## Claims

1. A polishing liquid comprising: abrasive grains; an additive; and water, wherein the additive includes (A1) a compound having two or more nitrogen atoms to which a hydroxyalkyl group is bonded and (B) a 4-pyrone-based compound represented by General Formula (1) below:

[Chemical Formula 1]

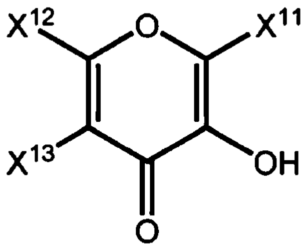

(1)

[in the formula, $X^{11}$, $X^{12}$, and $X^{13}$ are each independently a hydrogen atom or a monovalent substituent.]

2. The polishing liquid according to claim 1, wherein the component (A1) includes an ethylenedinitrilotetraethanol.

3. The polishing liquid according to claim 1, wherein the component (A1) includes an ethylenedinitrilotetrapropanol.

4. The polishing liquid according to claim 1, wherein a content of the component (A1) is 0.001 to 5% by mass.

5. A polishing liquid comprising: abrasive grains; an additive; and water, wherein
the additive includes (A2) a polyglycerol and (B) a 4-pyrone-based compound represented by General Formula (1) below:

[Chemical Formula 2]

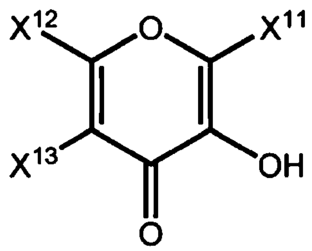

(1)

[in the formula, $X^{11}$, $X^{12}$, and $X^{13}$ are each independently a hydrogen atom or a monovalent substituent.]

6. The polishing liquid according to claim 5, wherein a content of the component (A2) is 0.001 to 10% by mass.

7. The polishing liquid according to any one of claims 1 to 6, wherein the abrasive grains contain a cerium-based compound.

8. The polishing liquid according to any one of claims 1 to 6, wherein the component (B) includes at least one selected from the group consisting of 3-hydroxy-2-methyl-4-pyrone, 5-hydroxy-2-(hydroxymethyl)-4-pyrone, and 2-ethyl-3-hydroxy-4-pyrone.

9. The polishing liquid according to any one of claims 1 to 6, wherein a content of the component (B) is 0.001 to 5% by mass.

10. The polishing liquid according to any one of claims 1 to 6, wherein the additive further includes a saturated monocarboxylic acid.

11. The polishing liquid according to any one of claims 1 to 6, wherein a pH is 8.00 or less.

12. A polishing liquid set, comprising:

constituent components of the polishing liquid according to any one of claims 1 to 6, separately stored as a first liquid and a second liquid, wherein
the first liquid contains the abrasive grains and water, and
the second liquid contains at least one of the additive, and water.

13. A polishing method comprising a step of polishing a surface to be polished of a member to be polished by using the polishing liquid according to any one of claims 1 to 6.

14. A method for manufacturing a component, comprising: obtaining a component by using a polished member polished by the polishing method according to claim 13.

15. A method for manufacturing a semiconductor component, comprising: obtaining a semiconductor component by using a polished member polished by the polishing method according to claim 13.

**INTERNATIONAL SEARCH REPORT**

International application No.
**PCT/JP2023/003437**

**A. CLASSIFICATION OF SUBJECT MATTER**

***H01L 21/304***(2006.01)i
FI: H01L21/304 622D

According to International Patent Classification (IPC) or to both national classification and IPC

**B. FIELDS SEARCHED**

Minimum documentation searched (classification system followed by classification symbols)

H01L21/304

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2016/006553 A1 (HITACHI CHEMICAL COMPANY, LTD.) 14 January 2016 (2016-01-14) paragraphs [0044]-[0181] | 1-15 |
| Y | WO 2012/161202 A1 (KURARAY CO., LTD.) 29 November 2012 (2012-11-29) paragraphs [0038]-[0040], [0042] | 1-4, 7-15 |
| Y | US 2020/0071566 A1 (SAMSUNG ELECTRONICS CO., LTD., KCTECH CO., LTD.) 05 March 2020 (2020-03-05) paragraphs [0004], [0034]-[0039] | 1-4, 7-15 |
| Y | WO 2022/070314 A1 (SHOWA DENKO MATERIALS CO., LTD.) 07 April 2022 (2022-04-07) paragraphs [0034]-[0035], [0064]-[0065] | 5-15 |
| Y | WO 2022/102019 A1 (SHOWA DENKO MATERIALS CO., LTD.) 19 May 2022 (2022-05-19) paragraphs [0040]-[0042], [0056]-[0057], [0076], [0084], [0089], [0100] | 5-15 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **23 March 2023** | **04 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

INTERNATIONAL SEARCH REPORT

International application No. **PCT/JP2023/003437**

**C. DOCUMENTS CONSIDERED TO BE RELEVANT**

| Category* | Citation of document, with indication, where appropriate, of the relevant passages | Relevant to claim No. |
|---|---|---|
| Y | JP 2020-517117 A (CABOT MICROELECTRONICS CORPORATION) 11 June 2020 (2020-06-11)<br>paragraphs [0018]-[0175] | 1-15 |

Form PCT/ISA/210 (second sheet) (January 2015)

**INTERNATIONAL SEARCH REPORT**
**Information on patent family members**

International application No.
**PCT/JP2023/003437**

| Patent document cited in search report | Publication date (day/month/year) | Patent family member(s) | Publication date (day/month/year) |
|---|---|---|---|
| WO 2016/006553 A1 | 14 January 2016 | US 2017/0210958 A1<br>paragraphs [0055]-[0249]<br>CN 106471090 A<br>KR 10-2017-0032335 A<br>TW 201606065 A | |
| WO 2012/161202 A1 | 29 November 2012 | US 2014/0154884 A1<br>paragraphs [0050]-[0052], [0054]<br>EP 2717297 A1<br>KR 10-2014-0034231 A<br>TW 201302998 A | |
| US 2020/0071566 A1 | 05 March 2020 | KR 10-2020-0025542 A<br>CN 110872473 A | |
| WO 2022/070314 A1 | 07 April 2022 | TW 202216946 A | |
| WO 2022/102019 A1 | 19 May 2022 | KR 10-2022-0066256 A<br>TW 202231803 A | |
| JP 2020-517117 A | 11 June 2020 | US 2018/0244956 A1<br>paragraphs [0019]-[0176]<br>TW 201839077 A<br>CN 110520493 A<br>KR 10-2019-0132537 A<br>WO 2018/194792 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2008288537 A